(19) Europäisches Patentamt
European Patent Office
Office européen des brevets

(11) **EP 3 652 569 B1**

(12) **EUROPÄISCHE PATENTSCHRIFT**

(45) Veröffentlichungstag und Bekanntmachung des Hinweises auf die Patenterteilung:
**14.08.2024  Patentblatt 2024/33**

(21) Anmeldenummer: **18729162.0**

(22) Anmeldetag: **12.06.2018**

(51) Internationale Patentklassifikation (IPC):
*G02B 5/08* (2006.01)       *H01L 33/62* (2010.01)
*H01L 33/60* (2010.01)      *H05K 1/11* (2006.01)

(52) Gemeinsame Patentklassifikation (CPC):
(C-Sets verfügbar)
**G02B 5/0858; C23C 4/06; H01L 33/60;**
**H01L 33/62; H05K 1/111;** H01L 24/32; H01L 24/48;
H01L 24/73; H01L 24/85; H01L 2224/32245;
H01L 2224/45144; H01L 2224/48091;
H01L 2224/48247; H01L 2224/48257;
H01L 2224/73265;                    (Forts.)

(86) Internationale Anmeldenummer:
**PCT/EP2018/065516**

(87) Internationale Veröffentlichungsnummer:
**WO 2019/011554 (17.01.2019 Gazette 2019/03)**

(54) **HERSTELLUNGSVERFAHREN FÜR EINE LICHTEMITTIERENDE VORRICHTUNG**

PRODUCTION METHOD FOR A LIGHT EMITTING DEVICE

MÉTHODE DE FABRICATION POUR UN APPAREILLAGE QUI ÉMET DE LA LUMIÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2017   DE 102017115798**
**12.10.2017   EP 17196142**

(43) Veröffentlichungstag der Anmeldung:
**20.05.2020   Patentblatt 2020/21**

(73) Patentinhaber: **ALANOD GmbH & Co. KG**
**58256 Ennepetal (DE)**

(72) Erfinder: **ZIEGLER, Stefan**
**45549 Sprockhövel (DE)**

(74) Vertreter: **Dr. Solf & Zapf**
**Patent- und Rechtsanwalts PartG mbB**
**Schlossbleiche 20**
**42103 Wuppertal (DE)**

(56) Entgegenhaltungen:
EP-A1- 2 416 389          EP-A2- 1 876 653
DE-A1- 102015 114 095     US-A1- 2014 175 495

(52) Gemeinsame Patentklassifikation (CPC): (Forts.)
H01L 2224/85205; H01L 2924/12035;
H01L 2924/12041; H01L 2933/0016; H05K 1/0209;
H05K 3/202; H05K 3/328; H05K 2201/0338;
H05K 2201/10106; H05K 2201/2054; Y02P 70/50

C-Sets
H01L 2224/48091, H01L 2924/00014;
H01L 2224/73265, H01L 2224/32245,
H01L 2224/48247, H01L 2924/00012;
H01L 2224/73265, H01L 2224/32245,
H01L 2224/48257, H01L 2924/00

## Beschreibung

Die vorliegende Erfindung betrifft ein reflektierendes Verbundmaterial, mit einem aus Aluminium bestehenden Träger, mit einer auf dem Träger befindlichen Zwischenschicht aus Aluminiumoxid und mit einem über der Zwischenschicht aufgebrachten, reflexionsverstärkenden optisch wirksamen Mehrschichtsystem. Unter einem "aus Aluminium bestehenden Träger" werden dabei auch Aluminiumlegierungen subsumiert.

Des Weiteren betrifft die vorliegende Erfindung eine lichtemittierende Vorrichtung mit einem derartigen reflektierenden Verbundmaterial.

Ein Verbundmaterial der eingangs genannten Art ist beispielsweise aus der WO 00/29784 A1 bekannt. Den Schwerpunkt dieser Anmeldung bildet dabei eine auf der Oberfläche des optisch wirksamen Systems befindliche Schutzschicht. Das reflexionsverstärkende optisch wirksame Mehrschichtsystem, welches auch als funktionelle Beschichtung bezeichnet wird, enthält dabei eine reflektierende Schicht, wie z. B. eine Schicht aus Aluminium, Silber, Kupfer, Gold, Chrom, Nickel oder deren Legierungen. Zwischen dem Träger und der funktionellen Beschichtung kann dabei als Zwischenschicht wenigstens eine Vorbehandlungsschicht angeordnet sein, welche im Falle eines Trägers aus Aluminium beispielsweise eine durch anodische Oxidation des Trägers erzeugte Schicht sein kann. Es wird dazu ausgeführt, dass es allgemein bekannt sei, Bänder aus Glänzwerkstoffen, z. B. aus Reinstaluminium auf Basis von Aluminium mit einem Reinheitsgrad von 99,8 % und größer, wie z. B. 99,9 %, oder aus AlMg-Legierungen, herzustellen, desgleichen auch Walzoberflächen mit diffuser oder gerichteter Lichtreflexion zu erzeugen. Es sei auch bekannt, zur Erhöhung der gerichteten Reflexion die Oberflächen von solchen Bändern chemisch oder elektrolytisch zu glänzen und anschließend durch anodische Oxidation eine Aluminiuoxid-Schutzschicht von z. B. 1,5 $\mu$m Schichtdicke zu erzeugen. Eine sich natürlicherweise auf Aluminium bildende Oxidschicht erreicht stattdessen nur eine Dicke von etwa 0,005 $\mu$m.

In der DE 103 40 005 A1 wird eine lichtemittierende Vorrichtung zur Aussendung von weißem Licht beschrieben, die ein nicht näher spezifiziertes, elektrisch isolierendes Substrat mit zwei Anschlusselektroden umfasst, welche an der oberen Oberfläche und an der Unterseite des Substrats vorgesehen sind. Die bekannte Vorrichtung umfasst dabei eine auf dem Substrat platzierte, als Chip ausgeführte lichtemittierende Diode (LED). Die Kathode dieser lichtemittierenden Diode ist mit einer der Elektroden durch ein Klebemittel verbunden, und die Anode ist mit der anderen Elektrode durch einen Bond-Draht verbunden. Die LED und die obere Oberfläche des Substrats sind von einem transparenten Harz bedeckt.

Charakteristisch für die in der DE 103 40 005 A1 praktizierte Montageweise ist dabei die sogenannte Oberflächenmontage des LED-Chips, der auch als "Die" (englisch für Würfel oder Plättchen) bezeichnet wird. Diese Montagetechnik wird in englischer Sprache als Surface-mounting technology "SMT" bezeichnet. Die außerdem in diesem Zusammenhang ebenfalls verwendete Abkürzung "SMD" (englisch: Surface-mounted device) beschreibt dabei das oberflächen montierte Bauelement, welches - im Gegensatz zu Bauelementen der herkömmlichen Durchsteckmontage (Through Hole Technology, "THT") mit "bedrahteten Bauelementen" - keine Drahtanschlüsse aufweist, sondern mittels insbesondere lötfähiger Anschlussflächen (hier in der DE 103 40 005 A1 allerdings mit einem Klebemittel) als so genannte Flachbaugruppe direkt auf einer Leiterplatte montiert wird.

Für derartige Anschlusselektroden-Strukturen ist auch die englische Bezeichnung "lead frame" üblich, wozu exemplarisch auf die US 6,407,411 B1 verwiesen wird. In diesem Zusammenhang ist zu erwähnen, dass im Bereich der SMD-LEDs als Material der "lead frames" heute üblicherweise versilbertes Kupfer verwendet wird, welches jedoch nachteiligerweise eine geringe Beständigkeit gegenüber Schwefelwasserstoff hat und eine Reflektivität in der Größenordnung von nur ca. 93% ausweist.

Bei der in der DE 103 40 005 A1 beschriebenen Montageweise handelt es sich außerdem um die Anwendung der sogenannten "COB-Technologie" (englisch: Chip-on-Board-Technology), die auch als Nacktchipmontage bezeichnet wird. Dies ist eine Technologie zur Direktmontage von ungehausten Halbleiter-Chips auf Platinen zur Herstellung von elektronischen Baugruppen. Heute verwendet man den Begriff "COB" für alle Baugruppen, die den nackten Halbleiter beinhalten, während man darunter ursprünglich ausschließlich nach der sogenannten Chip-and-Wire-Technik gefertigte Baugruppen verstand. Anmeldungsgemäß wird das neuere, weitere Verständnis zugrunde gelegt, wobei dieses die Chip-and-Wire-Technik, wie sie die DE 103 40 005 A1 für den LED-Chip vorsieht, inhaltlich umfasst.

Ein bedeutender Vorteil von LED-Vorrichtungen ist ihre hohe Lichtausbeute $\eta_v$ (englisch: luminous efficacy). Unter der Lichtausbeute wird der Quotient aus dem von einer Lichtquelle abgegebenen Lichtstrom $\Phi_v$ und der von ihr aufgenommenen Leistung P verstanden. Die SI-Einheit der Lichtausbeute ist Lumen pro Watt (lm/W). Je größer der Wert der Lichtausbeute ist, desto größer ist auch der für das Auge nutzbare Lichtstrom bei gegebener Leistungsaufnahme der Lampe. Die Lichtausbeute $\eta_v$ einer Lampe setzt sich dabei aus zwei Faktoren zusammen: der Strahlungsausbeute $\eta_e$ der Lampe und dem photometrischen Strahlungsäquivalent K der abgegebenen Strahlung.

$$\eta_v = \eta_e * K.$$

Während die Lichtausbeute einer herkömmlichen Glühlampe bei 10 bis 30 lm/Watt liegt, beträgt sie bei LED-Lampen vorteilhafterweise mehr als das Doppelte, nämlich 60 bis 100 lm/Watt.

In der EP 2 138 761 A1 wird ausgeführt, dass aus Aluminium bestehende, insbesondere beschichtete, Reflektoren zur Erzielung vergleichsweise hoher Beleuchtungsstärken bzw. Lichtausbeuten $\eta_v$ - d. h. hoher Wirkungsgrade - verwendet werden können. Der Gesamtreflexionsgrad eines als Reflektor eingesetzten hoch reflektierenden Trägers führt auch zu einer hohen Lichtausbeute. Dem Begriff "hoch reflektierend" wird dabei anmeldungsgemäß das gleiche Verständnis zugrunde gelegt, wie dieses in der genannten EP 2 138 761 A1 erläutert ist. Das heißt, im Folgenden werden unter "hoch reflektierend" Materialien verstanden, welche nach DIN 5036, Teil 3 (Ausgabe 11/79) einen Gesamtreflexionsgrad von mindestens 85 %, vorzugsweise von mindestens 90 %, besonders bevorzugt von mindestens 95 %, aufweisen.

Als Trägermaterial für Reflektoren mit hohem Gesamtreflexionsgrad wird - wie bereits erwähnt - weithin gewalztes Aluminium mit einer Mindestreinheit von 99,8 % verwendet, auf dem als Basis für darüber liegende PVD-Schichten und als chemische Schutzschicht die Zwischenschicht aufgebracht wird. Diese schützende Zwischenschicht entsteht bevorzugt in einem nasschemischen Eloxierprozess, wobei dadurch erreicht wird, dass die Oberfläche eine genügend geringe Rauigkeit und eine ausreichende Härte aufweist sowie defektfrei ausgebildet ist, wobei eventuell noch vorhandene Poren der Aluminiumoxidschicht in der letzten Phase der Prozesskette weitestgehend durch eine Heißverdichtung verschlossen werden können. Durch Änderungen der Reinheit und/oder der Rauheit kann dabei Einfluss auf die Höhe der Gesamtreflexion genommen werden, während durch gezielte Veränderungen der Walzstruktur des Aluminiumträgers ein Grad von diffuser Reflexion beeinflusst werden kann. Wenn das insbesondere bandförmige Aluminium-Trägermaterial zur Erzeugung der Zwischenschicht in das Bad zur anodischen Oxidation bzw. zum nasschemischen Eloxieren gebracht wird, entsteht sowohl auf seiner Oberseite die Aluminiumoxid-Zwischenschicht, als auch auf seiner Unterseite eine weitere Aluminiumoxid-Schicht mit im Wesentlichen gleichem Aufbau.

Das dann nachfolgend über der Zwischenschicht aufgebrachte optisch wirksame Mehrschichtsystem kann beispielsweise aus mindestens drei Schichten bestehen, wobei die oberen Schichten dielektrische und/oder oxidische Schichten sind, und die unterste Schicht eine metallische Schicht ist, welche eine Reflexionsschicht bildet. Hierbei kann es sich bei der metallischen Schicht z. B. um eine hochreflektierende Reinstsilber-Schicht handeln, die auf der Eloxalschicht abgeschieden ist. Sie ist optisch dicht und weist im sichtbaren Bereich des Lichtes eine extrem hohe Gesamtreflexion auf. Ein solches Verbundmaterial der eingangs genannten Art hat als oberflächenveredeltes Aluminiumband unter dem Namen MIRO®-Silver weite Verbreitung für die Beleuchtungstechnik, Tageslichtsysteme und dekorative Anwendungen gefunden.

Weitere bekannte Verbundmaterialien der eingangs genannten Art mit Silber-Reflexionsschichten sind in der DE 10 2015 114 095 A1 sowie in der WO 2017/032809 A1 beschrieben. Wegen ihres vorteilhaft hohen Gesamtreflexionsgrades und ihrer dabei exzellenten Langzeitstabilität erscheint es wünschenswert, diese und andere derartige Verbundmaterialien im Rahmen der vorstehend beschriebenen Surface-mounting- und Chip-on-Board-Technologien als Trägermaterial, z. B. als Lead-Frame-Strukturen, für Surface-mounted devices (SMD), insbesondere für LED-Halbleiter-Chips, einzusetzen. So wird in der DE 10 2015 114 095 A1 sowie in der WO 2017/032809 A1 die Platzierung von LED-Leuchtquellen, z. B. in Form eines Chips, auf der Oberfläche des dort beschriebenen Verbundmaterials als bevorzugter Anwendungsfall angesprochen. Jedoch hat sich gezeigt, dass die bekannten Verbundmaterialien im Rahmen der genannten Technologien, insbesondere auch bei Verwendung der Chip-and-Wire-Technik, zu Problemen bei der elektrischen Kontaktierung der SMD führen können Ein Verbundmaterial und die damit praktizierte Montage im wire-bonding-Verfahren ist aus EP1876653 bekannt.

Der vorliegenden Erfindung liegt die Aufgabe zugrunde, ein Verbundmaterial der eingangs beschriebenen Art mit hoher Reflektivität und vorzugsweise auch hoher Langzeitstabilität, d. h. mit einer langzeitlich geringen Einbuße des Licht-Gesamtreflexionsgrades, zu schaffen, das bei Anwendung einer Oberflächenmontage, insbesondere bei Anwendung der Chip-and-Wire-Technik, eine verbesserte elektrische Konnektierungsfähigkeit aufweist.

Diese Aufgabe wird erfindungsgemäß durch ein Herstellungsverfahren nach Anspruch 1 gelöst.

Vorteilhafterweise wird so erfindungsgemäß im Rahmen des sogenannten Wire-bondings einerseits ein Verschweißen eines Drahtes, insbesondere das Ultraschallschweißen eines Golddrahtes, auf der Vorder- bzw. Oberseite des erfindungsgemäßen Verbundmaterials zur Herstellung einer Verbindung zwischen der Oberfläche des Verbundmaterials und einem auf dem Verbundmaterial durch Oberflächenmontage aufgebrachten elektronischen Bauteil problemlos ermöglicht, und andererseits zeigt sich, dass der elektrische Übergangs-Widerstand auf der Rück- bzw. Unterseite des erfindungsgemäßen Verbundmaterials überraschenderweise vernachlässigbar klein ist. So kann diese Seite problemlos auf eine gedruckte Leiterplatte (englisch: Printed Circuit Board - PCB) gelötet oder mittels eines ähnlichen stoffschlüssig wirkenden Verbindungsverfahrens, z. B. unter Einsatz eines elektrisch leitenden Lackes oder auch Klebstoffs, aufgebracht werden. Die Auswahl des Materials und die Dicke der oberflächlich aufgebrachten Schicht eines Metalls oder einer Metalllegierung können vorteilhafterweise unter den verschiedensten Aspekten, wie beispielsweise Wert des spezifischen elektrischen Widerstandes, Temperaturbeständigkeit, insbesondere bei einem Löten, Lotkompatibilität, Verfügbarkeit, Preis usw. optimal aufeinander abgestimmt werden.

Bevorzugt kann es sich unter diesen Gesichtspunkten bei der oberflächlich aufgebrachten Schicht eines Metalls oder einer Metalllegierung um eine Kupferschicht mit einer Dicke im Bereich von 0,1 μm bis 5,0 μm oder um eine Silberschicht mit einer Dicke im Bereich von 10 nm bis 500 nm handeln.

Eine erfindungsgemäße lichtemittierende Vorrichtung umfasst das erfindungsgemäße reflektierende Verbundmaterial, welches eine Rahmen-Tragstruktur ("lead frame") für ein elektronisches Bauelement, wie eine als Nackt-Chip (Die) ausgebildete lichtemittierende Diode, bildet, wobei das elektronische Bauelement oberseitig auf der Rahmen-Tragstruktur aufliegt und befestigt ist sowie mittels eines separaten Drahtes elektrisch mit der Rahmen-Tragstruktur kontaktiert ist, und wobei der Verbund aus dem elektronischen Bauelement (als SMD) und der Rahmen-Tragstruktur ("lead frame") unterseitig mit einer gedruckten Leiterplatte (PCB) elektrisch leitend stoffschlüssig verbunden ist.

Der Ersatz der üblichen, aus silberplattiertem Kupfer bestehenden Rahmenstruktur durch das erfindungsgemäße Verbundmaterial bewirkt dabei, insbesondere wenn sich kein Silber in der oberflächlich aufgebrachten Schicht befindet, eine erhöhte Korrosionsbeständigkeit, insbesondere gegenüber Schwefelwasserstoff, wobei sich in jedem Fall gleichzeitig die Lichtausbeute erhöht, indem sie insbesondere Werte weit über 100 lm/W annehmen kann.

Weitere vorteilhafte Ausführungen der Erfindung sind in den Unteransprüchen und in der nachfolgenden detaillierten Beschreibung enthalten.

Anhand eines durch die beiliegende Zeichnung veranschaulichten Ausführungsbeispiels wird die Erfindung näher erläutert. Dabei zeigen:

Fig. 1    eine vergrößerte prinzipielle Schnittdarstellung durch eine Ausführungsform eines erfindungsgemäßen Verbundmaterials, wobei die darin enthaltenen Schichtdicken rein schematisch und nicht maßstabsgerecht dargestellt sind,

Fig. 2    eine Aufsicht auf einen Teilbereich einer Ausführungsform einer erfindungsgemäßen lichtemittierenden Vorrichtung,

Fig. 3    eine Aufsicht auf eine Ausführungsform einer aus einem erfindungsgemäßen Verbundmaterial gebildeten Rahmen-Tragstruktur für eine erfindungsgemäße lichtemittierende Vorrichtung und

Fig. 4    einen Querschnitt durch eine Ausführungsform einer erfindungsgemäßen lichtemittierenden Vorrichtung.

Zu der anschließenden Beschreibung wird ausdrücklich betont, dass die Erfindung nicht auf das Ausführungsbeispiel und dabei auch nicht auf alle oder mehrere Merkmale von beschriebenen Merkmalskombinationen beschränkt ist. Vielmehr kann jedes einzelne Teilmerkmal des Ausführungsbeispiels auch losgelöst von allen anderen im Zusammenhang damit beschriebenen Teilmerkmalen für sich und auch in Kombination mit beliebigen geeigneten weiteren Merkmalen eine erfinderische Bedeutung haben.

In den verschiedenen Figuren der Zeichnung sind dieselben Teile auch stets mit denselben Bezugszeichen versehen, so dass sie in der Regel auch jeweils nur einmal beschrieben werden.

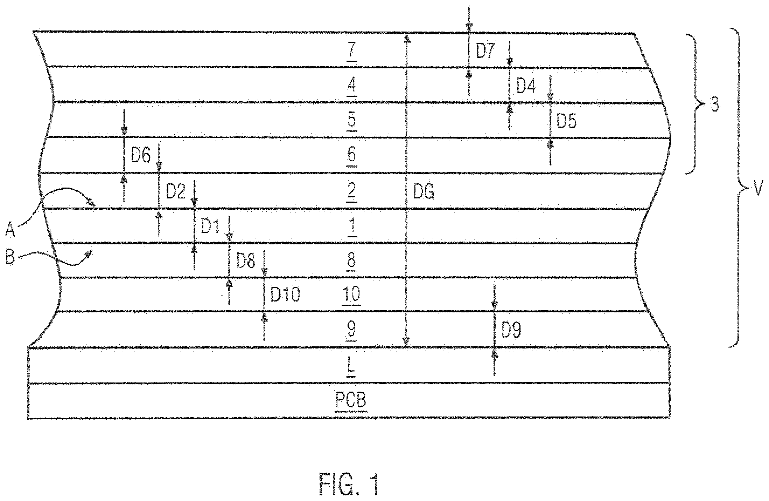

Wie zunächst aus Fig. 1 hervorgeht, weist ein erfindungsgemäßes reflektierendes Verbundmaterial V mit einem aus Aluminium bestehenden Träger 1, eine auf einer Seite A auf dem Träger 1 befindliche Zwischenschicht 2 aus Aluminiumoxid und ein auf der Zwischenschicht 2 aufgebrachtes, reflexionsverstärkendes optisch wirksames Mehrschichtsystem 3 auf. Der Träger 1 kann eine Ausbildung als Coil mit einer Breite bis zu 1600 mm, vorzugsweise von 1250 mm, und mit einer Dicke $D_1$ von etwa 0,1 bis 1,5 mm, vorzugsweise von etwa 0,2 bis 0,8 mm, aufweisen. Da alle auf dem Träger befindlichen dünnen Schichten, insbesondere die Zwischenschicht 2 und die des optisch wirksamen Mehrschichtsystems 3, demgegenüber vernachlässigbar klein sind, ist die Trägerdicke $D_1$ von ihrer Größe her auch gleichzeitig repräsentativ für eine Gesamtdicke DG des erfindungsgemäßen Verbundmaterials V.

Das Aluminium des Trägers 1 kann insbesondere eine höhere Reinheit als 99,0 % aufweisen, wodurch seine Wärmeleitfähigkeit gefördert wird. Dadurch kann die Entstehung von Wärmepeaks verhindert werden. Beispielsweise kann es sich bei dem Träger 1 aber auch um ein bandförmiges Aluminiumblech Al 98.3, also mit einer Reinheit von 98,3 Prozent handeln. Es ist auch möglich, als Träger 1 Aluminiumlegierungen, wie beispielsweise eine AlMg-Legierung, einzusetzen, insofern daraus durch anodische Oxidation die Zwischenschicht 2 gebildet werden kann.

Das optisch wirksame Mehrschichtsystem 3 kann exemplarisch - wie dargestellt - aus mindestens drei Schichten bestehen, wobei davon zwei obere Schichten 4, 5 dielektrische und/oder oxidische Schichten sind, und die darunter liegende unterste Schicht 6 eine metallische, z. B. aus Aluminum oder Silber bestehende, Schicht ist, welche eine Reflexionsschicht 6 bildet.

Zusätzlich ist im dargestellten Fall eine optional vorhandene, schützende nichtmetallische, aus einem absorptionsarmen Material, wie beispielsweise Siliciumdioxid, bestehende Deckschicht 7 dargestellt. Ein solcher Schichtaufbau ist aus dem deutschen Gebrauchsmuster DE 2 98 12 559 U1 bekannt, auf das in diesem Zusammenhang in vollem Umfang verwiesen wird. So können die dielektrischen und/oder oxidischen Schichten 4, 5 des optischen Mehrschichtsystems 3 beispielsweise jeweils eine Dicke $D_4$, $D_5$ im Bereich von 30 nm bis 200 nm, aufweisen, wobei diese Dicke $D_4$, $D_5$ jeweils bevorzugt ein Viertel der Mittenwellenlänge des Spektralbereiches der zu reflektierenden elektromagnetischen Strahlung beträgt, damit die Schichten 4, 5 als reflexionserhöhende Interferenzschichten wirken können. Eine Dicke $D_7$ der Schutzschicht 7 kann im Bereich von 0,5 nm bis 20 nm, vorzugsweise im Bereich von 0,5 nm bis 10 nm, liegen. Es kann auch vorgesehen sein, dass auf das optische Mehrschichtsystem 3 eine siliciumnitridische Schutzschicht als Deckschicht 7 aufgebracht ist.

Das optische Mehrschichtsystem 3 - einschließlich der Deckschicht 7 und vorteilhafterweise auch der noch nachstehend beschriebenen, insbesondere als Kupferschicht ausgebildeten, Schicht 9 eines Metalls oder einer Metalllegierung - kann in technologisch vorteilhafter Weise unter Anwendung eines kontinuierlichen Vakuum-Bandbeschichtungsprozesses appliziert werden. Insbesondere kann es sich dabei bei den Schichten 4, 5, 6, 7, 9 um Sputterschichten, insbesondere durch Reaktivsputtern erzeugte Schichten, CVD- oder PECVD-Schichten oder um durch Verdampfen, insbesondere durch Elektronenbombardement oder aus thermischen Quellen, erzeugte Schichten handeln.

Die Reflexionsschicht 6 kann optional über eine nicht dargestellte, beispielsweise aus Aluminium- Titan- und/oder Chromoxid bestehende, Haftvermittlerschicht an die Zwischenschicht 2 angebunden sein. Des Weiteren kann die Reflexionsschicht 6 optional ober- und unterseitig zwischen nicht dargestellten Barriereschichten, z. B. aus Nickel, Nickellegierungen oder Palladium, eingebettet sein, um die Temperaturstabilität zu erhöhen.

Die obere dielektrische und/oder oxidische Schicht 4 des optischen Mehrschichtsystems 3 ist eine höher brechende Schicht als die untere dielektrische und/oder oxidische Schicht 5 des optischen Mehrschichtsystems 3, wobei die obere Schicht 4 vorzugsweise aus $TiOz$, $Ta_2O_5$, $Nb_2O_5$, $MoOs$ und/oder $ZrO_2$, und die untere Schicht 5 vorzugsweise aus $Al_2O_3$ und/oder $SiO_2$ bestehen kann.

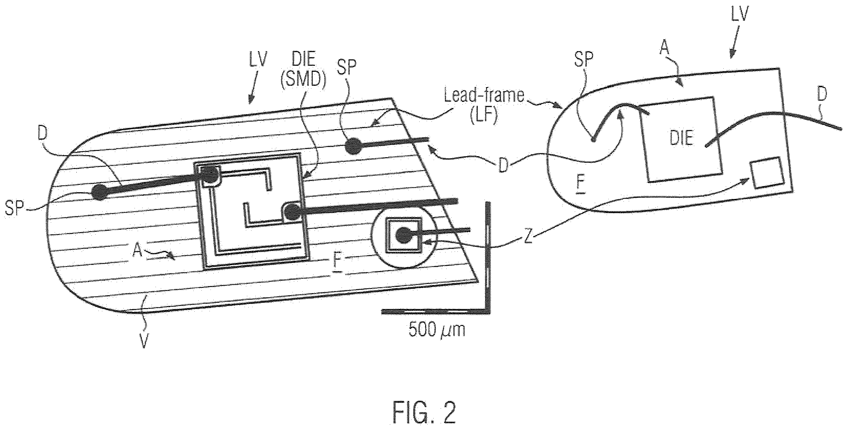

Erfindungsgemäß ist vorgesehen, dass die aus Aluminiumoxid bestehende, insbesondere aus anodisch oxidiertem Aluminium gebildete Zwischenschicht 2 eine Dicke $D_2$ im Bereich von 5 nm bis 200 nm, vorzugsweise im Bereich von 10 bis 100 nm, aufweist. Wie bereits ausgeführt, wird so - wie in Fig. 2 dargestellt - vorteilhafterweise erfindungsgemäß im Rahmen des sogenannten Wire-bondings einerseits ein Verschweißen eines Drahtes D, insbesondere das Ultraschallschweißen eines Golddrahtes, auf der Vorder- bzw. Oberseite A des erfindungsgemäßen Verbundmaterials V möglich, so dass eine elektrische Verbindung (Schweißpunkt SP) zwischen der Oberfläche A des Verbundmaterials V und einem auf dem Verbundmaterial V durch Oberflächenmontage aufgebrachten elektronischen Bauteil SMD problemlos möglich ist.

Hierbei ist es bevorzugt, dass die Oberfläche der Zwischenschicht 2 einen arithmetischen Mittenrauwert $R_a$ im Bereich von weniger als 0,05 $\mu$m, insbesondere von weniger als 0,01 $\mu$m, besonders bevorzugt von weniger als 0,005 $\mu$m, aufweist.

Dies dient bei Vorliegen des vorstehend genannten hohen Licht-Gesamtreflexionsgrades zur Einstellung eines nach DIN 5036 bestimmten, minimalen, diffusen Licht-Reflexionsgrades. Ist ein höherer diffuser Licht-Reflexionsgrad gefordert, kann die Rauheit entsprechend erhöht werden.

Auf der dem reflexionsverstärkenden optisch wirksamen Mehrschichtsystem 3 gegenüberliegenden Seite B des Trägers 1 befindet sich optional eine weitere aus Aluminiumoxid bestehende Schicht 8, die beispielsweise beim Eloxieren der Oberseite A herstellungsbedingt gleichzeitig entstehen kann. Ihre Ausbildung kann allerdings bedarfsweise durch eine Abdeckung der Seite B vermieden werden. Auch sind Verfahren bekannt, um derartige Schichten gegebenenfalls zu entfernen. Falls die weitere aus Aluminiumoxid bestehende Schicht 8 präsent ist, sollte ihre Dicke D8 im gleichen Bereich wie die Dicke $D_2$ der Zwischenschicht 2 liegen, also im Bereich von 5 nm bis 200 nm, vorzugsweise im Bereich von 10 bis 100 nm.

Ein weiteres erfindungswesentliches Merkmal besteht darin, dass auf der dem reflexionsverstärkenden, optisch wirksamen Mehrschichtsystem 3 gegenüberliegenden Seite B des Trägers 1 oberflächlich eine Schicht 9 eines Metalls oder einer Metalllegierung aufgebracht ist, welche(s) bei 25 °C einen spezifischen elektrischen Widerstand von maximal 1,2 * $10^{-1}$ $\Omega$ mm$^2$ / m aufweist, wobei die Dicke Dg der oberflächlich aufgebrachten Schicht 9 im Bereich von 10 nm bis 5,0 $\mu$m liegt.

Insbesondere kann es sich um eine Kupferschicht handeln, die mit einer Dicke $D_9$ im Bereich von 0,1 $\mu$m bis 5,0 $\mu$m, vorzugsweise im Bereich von 0,2 $\mu$m bis 3,0 $\mu$m, besonders bevorzugt im Bereich von 0,5 $\mu$m bis 1,5 $\mu$m aufgebracht ist.

Eine andere bevorzugte Ausführungsform der Erfindung sieht vor, dass die oberflächlich aufgebrachte Schicht 9 eine Silberschicht mit einer Dicke $D_9$ im Bereich von 10 nm bis 500 nm ist, insbesondere mit einer Dicke $D_9$ im Bereich von 50 nm bis 250 nm.

Der spezifische elektrische Widerstand der oberflächlich aufgebrachten Schicht 9 eines Metalls oder einer Metalllegierung kann bei 25 °C bevorzugt einen Maximalwert von 2,7 * $10^{-2}$ $\Omega$ mm$^2$ / m, besonders bevorzugt einen Maximalwert von 1,8 * $10^{-2}$ $\Omega$ mm$^2$ / m, aufweisen.

Hinsichtlich der Werte des spezifischen elektrischen Widerstandes, der dabei für verschiedene Materialien zugrunde zu legen ist, wird auf die nachfolgende Tabelle 1 verwiesen, die auf der Grundlage von in der Literatur an verschiedenen Stellen genannten Werten zusammengestellt ist.

Tabelle 1: Werte des spezifischen elektrischen Widerstandes ρ bei 25 °C

| MATERIAL | $\rho$ in $10^{-2}$ $\Omega$ mm$^2$ / m |
|---|---|
| $\rho \leq$ **1,8 * 10$^{-2}$** $\Omega$ **mm$^2$ / m** erfindungsgemäß besonders bevorzugt | |
| Ag | 1,59 |
| Cu | 1,69-1,72 |
| $\rho \leq$ **2,7 * 10$^{-2}$** $\Omega$ **mm$^2$ / m** erfindungsgemäß bevorzugt | |
| Al | 2,65 |
| Au | 2,21 |
| $\rho \leq$ **1,2 * 10$^{-1}$** $\Omega$ **mm$^2$ / m** erfindungsgemäß | |
| W | 5,3 |
| Ni | 6,9 - 7,1 |
| Pt | 10,5 |
| Pd | 10,7 |
| Sn | 10,9 |

Ein Überblick über spezifischen elektrischen Widerstand ρ von zehn verschiedenen binären Legierungen (Al/Cu, Al/Mg, Cu/Au, CulNi, CulPd, Cu/Zn, Au/Pd, Au/Ag, Fe/Ni, Ag/Pd) mit jeweils verschiedener Zusammensetzung ist beispielsweise dem wissenschaftlichen Artikel "Electrical resistivity of ten selected binary alloys systems", Autor: Ho, C. Y. et al., in J. Phys. Chem. Ref. Data, Vol. 12 No. 2, 1983, S. 183 bis 322 zu entnehmen. Bei Feststellung einer bestimmten chemischen Zusammensetzung in der erfindungsgemäß vorgesehenen Schicht 9 kann auf diese Werte Bezug genommen werden.

Es ist aber auch eine direkte Messung nach ASTM F390-11 "Standard Test Method for Sheet Resistance of Thin Metallic Films With a Collinear Four-Probe-Array" möglich. Diese Norm enthält auch Angaben darüber, wie ein in der Einheit $\Omega$ bzw. "$\Omega$ square" ermittelter Flächenwiderstand ("Sheet Resistance") unter Berücksichtigung der Schichtgeometrie, also von deren Länge, Breite und Dicke, in einen spezifischen elektrischen Widerstand umgerechnet werden kann.

Zwischen dem aus Aluminium bestehenden Träger 1 bzw. der weiteren optional vorhandenen aus Aluminiumoxid bestehenden Schicht 8 und der Kupferschicht 9 kann in bevorzugter Ausbildung eine Haftvermittlerschicht 10 vorgesehen sein, die z. B. aus einem Übergangsmetall, insbesondere aus Titan, Chrom oder Nickel, besteht und deren Dicke $D_{10}$ bevorzugt im Bereich von 5 nm bis 25 nm, besonders bevorzugt im Bereich 10 nm bis 20 nm, liegen kann.

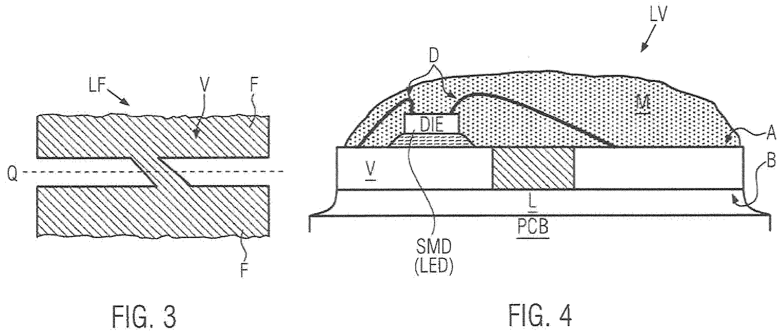

Wie ebenfalls bereits erwähnt, führt dies vorteilhafterweise dazu, dass der elektrische Übergangs-Widerstand auf der Rück- bzw. Unterseite B des erfindungsgemäßen Verbundmaterials V vernachlässigbar klein ist. So kann diese Seite B auf eine gedruckte Leiterplatte PCB gelötet oder mittels eines ähnlichen, stoffschlüssig wirkenden Verbindungsverfahrens aufgebracht werden. Die stoffschlüssig wirkende Verbindungsschicht ist in Fig. 1 und Fig. 4 jeweils mit dem Bezugszeichen L gekennzeichnet. Zum Verlöten können mit Vorteil beispielsweise zinnhaltige Standard-Elektrolote, wie z. B. Sn96.5Ag3Cu0.5, eingesetzt werden.

Trotz einer relativ dünnen Oberflächenschicht 9 des Metalls oder der Metalllegierung, insbesondere einer Kupferschicht, hat es sich gezeigt, dass es zwischen dem erfindungsgemäßen Verbundmaterial V und dem Lot nicht zu einer Ausbildung von relativ zur Schichtdicke $D_9$ dicken und spröden intermetallischen Phasen kommt, die durch thermische Spannungen zu einem mechanischen - und in der Folge auch zu einem elektrischen Versagen der Lötstelle - führen könnten. So führte eine Wärmelagerung von bis zu 1000 h nur zur Ausbildung einer wenige 100 nm dicken intermetallischen Phase. Es zeigte sich auch, dass die Lötverbindung der Verbindungsschicht L vorteilhafterweise typische Tests bestand, indem sich eine Abzugs- bzw. Scherkraft zwischen den verbundenen Bauteilen LF, COB nur um weniger als einen Faktor 2 nach einer Temperaturlagerung, z. B. bei 120 °C und 1000 h, reduzierte.

Auf der oberflächlich aufgebrachten Schicht 9 eines Metalls oder einer Metalllegierung, insbesondere auf der Kupferschicht, kann sich optional eine nicht dargestellte Passivierungsschicht befinden. Diese kann bevorzugt aus Ag, Ni, Pd und/oder Au (Ag/Ni/Pd/Au) bestehen und eine typische Dicke im Bereich von 10 nm bis 500 nm, bevorzugt im Bereich von 50 nm bis 250 nm, aufweisen. Eine derartige Schicht unterstützt aufgrund einer besseren Benetzbarkeit der Edelmetalloberfläche durch das Lot außerdem die Lötbarkeit des fertigen SMD-Bauteils auf das PCB.

Eine erfindungsgemäße lichtemittierende Vorrichtung LV - siehe dazu Fig. 2 und Fig. 4 - umfasst das erfindungsgemäße reflektierende Verbundmaterial V, welches eine Rahmen-Tragstruktur LF ("lead frame") für das elektronisches Bauelement SMD, wie eine als Nackt-Chip DIE ausgebildete, lichtemittierende Diode, bilden kann. Eine derartige Rahmen-Tragstruktur LF ist in Fig. 3 dargestellt. Sie besitzt in der dargestellten Form in der Draufsicht die Form eines H, wobei dessen Querbalken Q zwischen den als Fingern F bezeichneten Bahnen nicht rechtwinklig, sondern - wie dargestellt - häufig schräg verläuft. Eine derartige Rahmen-Tragstruktur LF kann in technologisch vorteilhafter Weise z. B. als Stanzteil oder durch Laserschneiden hergestellt werden. Bedarfsweise ist auch eine zusätzliche Ausbildung als Biegeteil möglich, da das Verbundmaterial V ohne Qualitätsverlust problemlos gebogen werden kann.

Hierbei kann eine Vielzahl von Rahmen-Tragstrukturen LF zunächst in einer als bandförmige Platine ausgebildeten Rahmen-Vorrichtung vereinigt sein, in der die Rahmen-Tragstrukturen LF über Stege feldförmig, d. h. als Zeilen- und Spaltenelemente, eingebunden sind. Aus der Rahmen-Vorrichtung können die Rahmen-Tragstrukturen LF einfach entfernt, beispielsweise herausgebrochen oder gestanzt, werden, so dass eine insbesondere automatisierte Massenproduktion von erfindungsgemäßen lichtemittierenden Vorrichtungen LV vorteilhafterweise leicht möglich ist. Die Rahmen-Tragstrukturen LF können dabei oberseitig bereits mit elektronischen Chips SMD bestückt werden.

In der erfindungsgemäßen lichtemittierenden Vorrichtung LV liegt das elektronische Bauelement SMD/DIE oberseitig, also auf der Seite A auf der Rahmen-Tragstruktur LF, auf und ist mittels mindestens eines separaten Drahtes D elektrisch mit der Rahmen-Tragstruktur LF kontaktiert. Neben dem LED-Die (Bezugszeichen: DIE) ist in Fig. 2 zusätzlich unten rechts eine Zener-Diode Z als weiteres oberflächenmontiertes elektronisches Bauteil SMD dargestellt. Der Verbund aus dem elektronischen Bauelement SMD bzw. - im dargestellten Fall den beiden dargestellten elektronischen Bauelementen SMD (DIE und Z) - und der Rahmen-Tragstruktur LF ist unterseitig (Seite B) mit einer gedruckten Leiterplatte PCB elektrisch leitend stoffschlüssig verbunden.

Auf dem Träger 1 können sich - abweichend von dem dargestellten Ausführungsbeispiel - auch andere reflexionsverstärkende Systeme 3 mit weiteren Schichten befinden. Diesbezüglich ist insbesondere dasjenige der DE 10 2015 114 095 A1 mit der reflexionsverstärkenden Silberschicht zu nennen, sofern es erfindungsgemäß ausgestaltet wird. Das in der WO 2017/032809 A1 beschriebene System sieht dagegen in der Zwischenschicht 2 zwingend die Präsenz eines organischen schichtbildenden Lackes mit bis zu 5 $\mu$m Dicke vor, was erfindungsgemäß vermieden werden sollte. Die Formulierung "Zwischenschicht 2 aus Aluminiumoxid" ist anmeldungsgemäß bevorzugt im Sinne von "ausschließlich bestehend aus" als abschließend zu betrachten, jedoch ist anmeldungsgemäß die Existenz von Teilschichten in der Zwischenschicht 2 gegebenenfalls nicht völlig auszuschließen. Unter diesem Gesichtspunkt sollte dann jedoch in jedem Fall die Dicke $D_2$ der gesamten Zwischenschicht 2 im Bereich von 5 nm bis 200 nm liegen.

Wenngleich das optische Mehrschichtsystem 3 nicht nur die vorstehend beschriebenen Schichten 4, 5, 6 aufweisen kann, so darf erfindungsgemäß jedoch nicht vorgesehen sein, dass darauf als Deckschicht 7 eine organische oder siliciumorganische Lackschicht, z. B. auf der Basis einer Sol-Gel-Schicht, wie sie ebenfalls im Stand der Technik beschrieben ist, aufgebracht wird.

Der Fachmann kann im Rahmen der Ansprüche weitere zweckmäßige Ausgestaltungsformen der Erfindung vorsehen, ohne dass der Rahmen der Erfindung verlassen wird. So ist beispielsweise in Fig. 4 die Oberfläche der erfindungsgemäßen lichtemittierende Vorrichtung LV mit einer transparenten Masse M, z. B. mit einem Epoxidharz, vergossen. Alternativ oder zusätzlich könnten auch optische Linsensysteme über dem als LED-Chip DIE ausgebildeten elektronischen Bauteil SMD vorgesehen sein.

Insofern vorstehend von einer Silberschicht, insbesondere als Reflexionsschicht 6, die Rede ist, so schließt dies ein, dass eine solche Schicht Legierungselemente im Bereich von 0,001 Masseprozent bis 5,0 Masseprozent, insbesondere im Bereich von 0,5 Masseprozent bis 3,0 Masseprozent, enthalten kann. Bei den Legierungselementen kann es sich beispielsweise um ein Seltenerdelement, wie Neodym, handeln. Derartige Elemente können z. B. an die Korngrenzen des Silbers migrieren und/oder sich an der Oberfläche der Silberschicht anreichern, so dass sie dort eher als das edlere Silber oxidieren und auf den Silberkörnern eine mikroskopisch dünne Schutzschicht bilden. Die Wirksamkeit dieser Legierungselemente kann durch eine zusätzliche Zulegierung von Palladium, Platin, Gold und/oder Kupfer noch gesteigert werden. Auch wird dadurch eine Diffusionshemmung bewirkt, sowie einer Koaleszenz von Silberkristalliten, insbesondere bei höheren Temperaturen, wie sie im Betriebszustand auftreten können, entgegengewirkt. Dadurch kommt es vorteilhafterweise zu einer Entschleunigung der Alterung der Reflexionsschicht, d. h. einer Verzögerung des Abfalls der Reflektivität über die Zeit und/oder die Temperatur,

Palladium kann dem Silber auch als Hauptlegierungselement, vorzugsweise in einem Masseanteil im Bereich von 0,5 Masseprozent bis 3,0 Masseprozent der Legierung, zulegiert werden, wobei zusätzlich - in kleinerem oder höchstens dem gleichen Anteil - eines der Elemente Aluminium, Gold, Platin, Kupfer, Tantal, Chrom, Titan, Nickel, Kobalt oder Silizium als dritte Legierungskomponente präsent sein kann.

Silberschichten können auch, jedoch in vergleichsweise höheren Anteilen - insbesondere mit bis zu 70 Masseprozent, vorzugsweise im Bereich von 5 Masseprozent bis 30 Masseprozent, mit Molybdän legiert werden. Dies bewirkt ebenfalls eine Diffusionshemmung und außerdem eine verbesserte Haftfähigkeit des Silbers.

Auch Indium, Titan und/oder Zinn können als Legierungselemente für das Silber vorgesehen sein. Diesbezüglich erscheint beispielsweise eine Legierung als geeignet, die vorzugsweise Indium und/oder Zinn und/oder auch Antimon und/oder Wismut im Bereich von 0,5 Masseprozent bis 3,0 Masseprozent enthält, wobei der Rest aus Silber besteht.

Ein geeignetes Target, um in einem Sputterprozess Silber-Legierungsschichten zu erzeugen, ist auch in der EP 3 196 334 A1 beschrieben.

**Bezugszeichenliste**

| 1 | Träger von V |
|---|---|
| 2 | Zwischenschicht von V auf 1 (Seite A) |
| 3 | optisch wirksames Mehrschichtsystem von V auf 2 (Seite A) |
| 4, 5 | obere Schichten von 3 (Seite A) |
| 6 | unterste Schicht von 3, Reflexionsschicht (Seite A) |
| 7 | Deckschicht von V über 3 (Seite A) |
| 8 | $Al_2O_3$-Schicht von V auf 1 (Seite B) |
| 9 | Schicht eines Metalls oder einer Metalllegierung (Seite B) |

| A | Oberseite von 1 |
|---|---|
| B | Unterseite von 1 |
| D | Draht |
| $D_1$ | Dicke von 1 |
| $D_2$ | Dicke von 2 |
| Da | Dicke von 3 |
| $D_4$ | Dicke von 4 |
| $D_5$ | Dicke von 5 |
| $D_6$ | Dicke von 6 |
| $D_7$ | Dicke von 7 |
| $D_8$ | Dicke von 8 |
| $D_9$ | Dicke von 9 |
| DG | Gesamtdicke von V |
| DIE | lichtemittierende Diode, Nacktchip-Ausführungsform von SMD (Fig. 2, 4) |
| F | H-Finger von LF (Fig. 2, 3) |
| L | Verbindungsschicht zwischen V und PCB |
| LF | Rahmen-Tragstruktur (lead frame) |
| LV | lichtemittierende Vorrichtung mit V |
| M | transparente Masse von LV (Fig. 4) |
| PCB | printed circuit board |
| Q | H-Querbalken von LF (Fig. 3) |
| SMD | elektronisches Bauelement (surface mounted device) |
| SP | Schweißpunkt (Fig. 2) |
| V | Verbundmaterial |
| Z | Zenerdiode, Ausführungsform von SMD (Fig. 2) |

**Patentansprüche**

1. Verfahren zur Herstellung einer lichtemittierenden Vorrichtung (LV), umfassend eine Rahmen-Tragstruktur (LF) für ein elektronisches Bauelement (SMD), wobei das elektronische Bauelement (SMD) auf der Oberseite (A) auf der Rahmen-Tragstruktur (LF) aufgelegt und befestigt wird sowie mittels eines separaten Drahtes (D) elektrisch mit der Rahmen-Tragstruktur (LF) kontaktiert wird, und wobei der Verbund aus dem elektronischen Bauelement (SMD) und der Rahmen-Tragstruktur (LF) auf der Unterseite (B) mit einer Leiterplatte (PCB) elektrisch leitend stoffschlüssig verbunden wird,

   **dadurch gekennzeichnet, dass** die Rahmen-Tragstruktur (LF) aus einem reflektierenden Verbundmaterial (V) mit einem aus Aluminium bestehenden Träger (1), mit einer auf einer Seite (A) auf dem Träger (1) befindlichen Zwischenschicht (2) aus Aluminiumoxid und mit einem auf der Zwischenschicht (2) aufgebrachten, reflexionsverstärkenden optisch wirksamen Mehrschichtsystem (3) gebildet wird, wobei
   die aus Aluminiumoxid bestehende Zwischenschicht (2) eine Dicke ($D_2$) im Bereich von 5 nm bis 200 nm aufweist und auf der dem reflexionsverstärkenden optisch wirksamen Mehrschichtsystem (3) gegenüberliegenden Seite (B) des Trägers (1) oberflächlich eine Schicht (9) eines Metalls oder einer Metalllegierung aufgebracht ist, welche(s) bei 25 °C einen spezifischen elektrischen Widerstand von maximal $1,2 * 10^{-1}$ $\Omega$ mm$^2$ / m aufweist, wobei die Dicke ($D_9$) der oberflächlich aufgebrachten Schicht (9) im Bereich von 10 nm bis 5,0 $\mu$m liegt.

2. Verfahren nach Anspruch 1,
**dadurch gekennzeichnet, dass** die auf der dem reflexionsverstärkenden optisch wirksamen Mehrschichtsystem (3) gegenüberliegenden Seite (B) des Trägers (1) oberflächlich aufgebrachte Schicht (9) eines Metalls oder einer Metalllegierung bei 25 °C einen spezifischen elektrischen Widerstand von maximal $2,7 * 10^{-2}$ $\Omega$ mm$^2$ / m, bevorzugt von maximal $1,8 * 10^{-2}$ $\Omega$ mm$^2$ / m, aufweist.

3. Verfahren nach Anspruch 1 oder 2,
**dadurch gekennzeichnet, dass** die aus Aluminiumoxid bestehende Zwischenschicht (2) eine Dicke ($D_2$) im Bereich von 10 bis 100 nm aufweist.

4. Verfahren nach einem der Ansprüche 1 bis 3,
**dadurch gekennzeichnet, dass** zwischen dem aus Aluminium bestehenden Träger (1) und der oberflächlich aufgebrachten Schicht (9) eines Metalls oder einer Metalllegierung (9) eine Haftvermittlerschicht (10) aus einem Übergangsmetall, insbesondere aus Titan, Chrom oder Nickel, angeordnet ist.

5. Verfahren nach einem der Ansprüche 1 bis 4,
**dadurch gekennzeichnet, dass** die oberflächlich aufgebrachte Schicht (9) eines Metalls oder einer Metalllegierung eine Kupferschicht ist, insbesondere mit einer Dicke ($D_9$) im Bereich von 0,1 $\mu$m bis 5,0 $\mu$m, vorzugsweise im Bereich von 0,2 $\mu$m bis 3,0 $\mu$m, besonders bevorzugt im Bereich von 0,5 $\mu$m bis 1,5 $\mu$m.

6. Verfahren nach einem der Ansprüche 1 bis 4,
**dadurch gekennzeichnet, dass** die oberflächlich aufgebrachte Schicht (9) eines Metalls oder einer Metalllegierung eine Silberschicht ist, insbesondere mit einer Dicke ($D_9$) im Bereich von 10 nm bis 500 nm, bevorzugt im Bereich von 50 nm bis 250 nm.

7. Verfahren nach einem der Ansprüche 1 bis 6,
**dadurch gekennzeichnet, dass** auf der oberflächlich aufgebrachten Schicht (9) eines Metalls oder einer Metalllegierung eine Passivierungsschicht abgeschieden ist, die bevorzugt aus Ag, Ni, Pd und/oder Au besteht und eine Dicke im Bereich von 10 nm bis 500 nm, bevorzugt im Bereich von 50 nm bis 250 nm aufweist.

8. Verfahren nach einem der Ansprüche 1 bis 7,
**dadurch gekennzeichnet, dass** eine Silberschicht als oberflächlich aufgebrachte Schicht (9) eines Metalls oder einer Metalllegierung und/oder als eine darauf befindliche Passivierungsschicht und/oder als eine Reflexionsschicht (6) des reflexionsverstärkenden optisch wirksamen Mehrschichtsystems (3) legiert ist und als Legierungselement(e) ein oder mehrere Seltenerdelemente und/oder Palladium, Platin, Gold, Kupfer, Indium, Titan, Zinn und/oder Molybdän enthält.

9. Verfahren nach einem der Ansprüche 1 bis 8,
**dadurch gekennzeichnet, dass** eine oder mehrere der über der Zwischenschicht (2) angeordneten Schichten (4, 5, 6, 7), insbesondere des optischen Mehrschichtsystems (3), sowie die oberflächlich aufgebrachte Schicht (9) eines Metalls oder einer Metalllegierung und/oder die Passivierungsschicht Sputterschichten, insbesondere durch Reaktivsputtern erzeugte Schichten, CVD- oder PECVD-Schichten oder durch Verdampfen, insbesondere durch Elektronenbombardement oder aus thermischen Quellen, erzeugte Schichten sind.

10. Verfahren nach einem der Ansprüche 1 bis 9,
**dadurch gekennzeichnet, dass** das Aluminium des Trägers (1) eine höhere Reinheit als 99,0 % aufweist.

11. Verfahren nach einem der Ansprüche 1 bis 10,
**dadurch gekennzeichnet, dass** der Träger (1) eine Dicke ($D_1$) von 0,1 bis 1,5 mm, vorzugsweise von 0,2 bis 0,8 mm, aufweist.

12. Verfahren nach einem der Ansprüche 1 bis 11,
**dadurch gekennzeichnet, dass** die Rahmen-Tragstruktur (LF) insbesondere in der Draufsicht die Form eines H besitzt, dessen Querbalken (Q) zwischen als aus Fingern (F) ausgebildeten Bahnen vorzugsweise schräg verläuft.

**13.** Verfahren nach einem der Ansprüche 1 bis 12,
**dadurch gekennzeichnet, dass** die Rahmen-Tragstruktur (LF) als Stanz- und/oder Biegeteil oder durch Laserschneiden hergestellt wird.

**14.** Verfahren nach Anspruch 13,
**dadurch gekennzeichnet, dass** das Verbundmaterial (V) als Rahmen-Vorrichtung in Form einer bandförmigen Platine ausgebildet wird, in der über Stege eine Vielzahl von Rahmen-Tragstrukturen (LF) als Zeilen- und Spaltenelemente feldförmig vereinigt ist.

**15.** Verfahren nach einem der Ansprüche 1 bis 14,
**dadurch gekennzeichnet, dass** die Rahmen-Tragstruktur (LF) mit der Leiterplatte (PCB) über eine zinnhaltige Lotschicht (L) verbunden wird.

**16.** Verfahren nach einem der Ansprüche 1 bis 15,
**dadurch gekennzeichnet, dass** das elektronische Bauelement (SMD) eine als Chip (DIE) ausgebildete lichtemittierende Diode (LED) ist.

**Claims**

**1.** Method for producing a light-emitting device (LV), comprising a frame supporting structure (LF) for an electronic component (SMD), the electronic component (SMD) being placed and fastened on the upper side (A) on the frame supporting structure (LF) and being electrically contacted with the frame supporting structure (LF) by means of a separate wire (D), and wherein the composite of the electronic component (SMD) and the frame support structure (LF) is electrically conductively bonded to a printed circuit board (PCB) on the underside (B),

**characterized in that** the frame supporting structure (LF) is composed of a reflective composite material (V) with a carrier (1) consisting of aluminum, with an intermediate layer (2) of aluminum oxide located on one side (A) on the carrier (1) and with a reflection-enhancing, optically effective multilayer system (3) applied to the intermediate layer (2), wherein
the intermediate layer (2) consisting of aluminum oxide has a thickness (D ) in the range from 5 nm to 200 nm and a layer (9) of a metal or a metal alloy is applied to the surface of the side (B) of the substrate (1) opposite the reflection-enhancing optically effective multilayer system (3), which has a specific electrical resistance of at most $1.2 * 10\ \Omega$ mm / m at 25 °C, the thickness (D ) of the superficially applied layer (9) being in the range from 10 nm to 5.0 $\mu$m.

**2.** Method according to claim 1,
**characterized in that** the layer (9) of a metal or a metal alloy applied to the surface of the side (B) of the substrate (1) opposite the reflection-enhancing optically effective multilayer system (3) has a specific electrical resistance at 25 °C of at most $2.7 * 10\ \Omega$ mm / m, preferably of at most $1.8 * 10\ \Omega$ mm / m.

**3.** Method according to claim 1 or 2,
**characterized in that** the intermediate layer (2) consisting of aluminium oxide has a thickness ($D_2$) in the range from 10 to 100 nm.

**4.** Method according to any one of claims 1 to 3,
**characterized in that** an adhesion promoter layer (10) of a transition metal, in particular of titanium, chromium or nickel, is arranged between the carrier (1) consisting of aluminium and the superficially applied layer (9) of a metal or a metal alloy (9).

**5.** Method according to any one of claims 1 to 4,
**characterized in that** the superficially applied layer (9) of a metal or a metal alloy is a copper layer, in particular with a thickness ($D_9$) in the range from 0.1 $\mu$m to 5.0 $\mu$m, preferably in the range from 0.2 $\mu$m to 3.0 $\mu$m, particularly preferably in the range from 0.5 $\mu$m to 1.5 $\mu$m.

**6.** Method according to any one of claims 1 to 4,
**characterized in that** the superficially applied layer (9) of a metal or a metal alloy is a silver layer, in particular with a thickness ($D_9$) in the range from 10 nm to 500 nm, preferably in the range from 50 nm to 250 nm.

7. Method according to any one of claims 1 to 6,
**characterized in that** a passivation layer, which preferably consists of Ag, Ni, Pd and/or Au and has a thickness in the range from 10 nm to 500 nm, preferably in the range from 50 nm to 250 nm, is deposited on the superficially applied layer (9) of a metal or a metal alloy.

8. Method according to any one of claims 1 to 7,
**characterized in that** a silver layer is alloyed as a superficially applied layer (9) of a metal or a metal alloy and/or as a passivation layer located thereon and/or as a reflection layer (6) of the reflection-enhancing optically effective multilayer system (3) and contains one or more rare earth elements and/or palladium, platinum, gold, copper, indium, titanium, tin and/or molybdenum as alloying element(s).

9. Method according to any one of claims 1 to 8,
**characterized in that** one or more of the layers (4, 5, 6, 7) arranged above the intermediate layer (2), in particular of the optical multilayer system (3), as well as the superficially applied layer (9) of a metal or a metal alloy and/or the passivation layer are sputter layers, in particular layers produced by reactive sputtering, CVD or PECVD layers or layers produced by evaporation, in particular by electron bombardment or from thermal sources.

10. Method according to any one of claims 1 to 9,
**characterized in that** the aluminium of the carrier (1) has a purity higher than 99.0 %.

11. Method according to any one of claims 1 to 10,
**characterized in that** the carrier (1) has a thickness ($D_1$) of 0.1 to 1.5 mm, preferably of 0.2 to 0.8 mm.

12. Method according to any one of claims 1 to 11,
**characterized in that** the frame supporting structure (LF) has the shape of an H, in particular in plan view, whose crossbar (Q) preferably runs obliquely between webs formed as fingers (F).

13. Method according to one of claims 1 to 12,
**characterized in that** the frame support structure (LF) is produced as a die-cut and/or bent part or by laser cutting.

14. Method according to claim 13,
**characterized in that** the composite material (V) is designed as a frame device in the form of a band-shaped printed circuit board, in which a plurality of frame supporting structures (LF) are combined in a field-like manner as row and column elements via bars.

15. Method according to any one of claims 1 to 14,
**characterized in that** the frame support structure (LF) is connected to the printed circuit board (PCB) via a tin-containing solder layer (L).

16. Method according to any one of claims 1 to 15,
**characterized in that** the electronic component (SMD) is a light-emitting diode (LED) in the form of a chip (DIE).

**Revendications**

1. Procédé de fabrication d'un dispositif électroluminescent (LV), comprenant une structure de support formant cadre (LF) destinée à un composant électronique (SMD), le composant électronique (SMD) étant placé et fixé sur le côté supérieur (A) de la structure de support formant cadre (LF) et étant en contact électrique avec la structure de support formant cadre (LF) au moyen d'un fil séparé (D), et le composite formé du composant électronique (SMD) et de la structure de support formant cadre (LF) étant relié électriquement par une liaison de matière à une carte de circuit imprimé (PCB) sur le côté inférieur (B), **caractérisé en ce que** la structure de support formant cadre (LF) est formée à partir d'une matière composite réfléchissante (V) comprenant un support (1) en aluminium, une couche intermédiaire (2) en oxyde d'aluminium située sur un côté (A) du support (1) et un système multicouche (3) qui est appliqué sur la couche intermédiaire (2) et dont l'effet optique est d'améliorer la réflexion, la couche intermédiaire (2) en oxyde d'aluminium ayant une épaisseur ($D_2$) dans la gamme allant de 5 nm à 200 nm et une couche (9) d'un métal ou d'un alliage métallique, qui présente une résistance électrique spécifique d'un maximum de $1{,}2 * 10^{-1}$ $\Omega$ mm$^2$/m à 25°C, étant appliquée en surface sur le côté (B) du support (1) qui est opposé au système multicouche (3) dont l'effet optique est d'améliorer la réflexion, l'épaisseur (Dg) de la couche (9) appliquée en surface étant dans la gamme allant de 10 nm à 5,0 $\mu$m.

2. Procédé selon la revendication 1,
   **caractérisé en ce que** la couche (9) en métal ou alliage métallique, qui est appliquée en surface sur le côté (B) du support (1) opposé au système multicouche (3) dont l'effet optique est d'améliorer la réflexion, présente une résistance électrique spécifique d'un maximum de 2,7*10$^{-2}$ $\Omega$ mm$^2$/m, de préférence d'un maximum de 1,8*10$^{-2}$ $\Omega$ mm$^2$/m, à 25°C.

3. Procédé selon la revendication 1 ou 2,
   **caractérisé en ce que** la couche intermédiaire (2) en oxyde d'aluminium a une épaisseur ($D_2$) dans la gamme allant de 10 à 100 nm.

4. Procédé selon l'une des revendications 1 à 3, **caractérisé en ce qu'**une couche de promoteur d'adhérence (10) en métal de transition, en particulier en titane, en chrome ou en nickel, est disposée entre le support (1) en aluminium et la couche (9) en métal ou en alliage métallique (9) appliquée en surface.

5. Procédé selon l'une des revendications 1 à 4, **caractérisé en ce que** la couche (9) en métal ou alliage métallique appliquée en surface est une couche de cuivre, notamment d'une épaisseur ($D_9$) dans la gamme allant de 0,1 $\mu$m à 5,0 $\mu$m, de préférence dans la gamme allant de 0,2 $\mu$m à 3,0 $\mu$m, de manière particulièrement préférée dans la gamme allant de 0,5 $\mu$m à 1,5 $\mu$m.

6. Procédé selon l'une des revendications 1 à 4, **caractérisé en ce que** la couche (9) en métal ou alliage métallique appliquée en surface est une couche d'argent, notamment d'une épaisseur ($D_9$) dans la gamme allant de 10 nm à 500 nm, de préférence dans la gamme allant de 50 nm à 250 nm.

7. Procédé selon l'une des revendications 1 à 6, **caractérisé en ce qu'**une couche de passivation, qui comprend de préférence de l'Ag, du Ni, du Pd et/ou de l'Au et qui a une épaisseur dans la gamme allant de 10 nm à 500 nm, de préférence dans la gamme allant de 50 nm à 250 nm, est déposée sur la couche (9) en métal ou alliage métallique appliquée en surface.

8. Procédé selon l'une des revendications 1 à 7, **caractérisé en ce qu'**une couche d'argent est alliée comme couche (9) en métal ou alliage métallique appliquée en surface et/ou comme couche de passivation située sur celle-ci et/ou comme couche de réflexion (6) du système multicouche (3) dont l'effet optique est d'améliorer la réflexion et contient un ou plusieurs éléments de terres rares et/ou du palladium, du platine, de l'or, du cuivre, de l'indium, du titane, de l'étain et/ou du molybdène comme éléments d'alliage.

9. Procédé selon l'une des revendications 1 à 8, **caractérisé en ce qu'**une ou plusieurs des couches (4, 5, 6, 7) disposées au-dessus de la couche intermédiaire (2), en particulier du système multicouche optique (3), ainsi que la couche (9) en métal ou alliage métallique appliquée en surface et/ou la couche de passivation sont des couches de pulvérisation, notamment des couches générées par pulvérisation réactive, des couches CVD ou PECVD ou des couches générées par évaporation, notamment par bombardement électronique ou à partir de sources thermiques.

10. Procédé selon l'une des revendications 1 à 9, **caractérisé en ce que** l'aluminium du support (1) a une pureté supérieure à 99,0 %.

11. Procédé selon l'une des revendications 1 à 10, **caractérisé en ce que** le support (1) a une épaisseur ($D_1$) de 0,1 à 1,5 mm, de préférence de 0,2 à 0,8 mm.

12. Procédé selon l'une des revendications 1 à 11, **caractérisé en ce que** la structure de support formant cadre (LF), notamment en vue de dessus, a la forme d'un H dont la barre transversale (Q) s'étend de préférence obliquement entre des pistes formées de doigts (F).

13. Procédé selon l'une des revendications 1 à 12, **caractérisé en ce que** la structure de support formant cadre (LF) est réalisée sous forme de pièce estampée et/ou pliée ou par découpe laser.

14. Procédé selon la revendication 13,
    **caractérisé en ce que** la matière composite (V) est conçue comme un dispositif formant cadre sous la forme d'une carte de circuit imprimé en forme de bande dans laquelle un grand nombre de structures de support formant cadre (LF) sont combinées en zone sous forme d'éléments de lignes et de colonnes par le biais d'entretoises.

**15.** Procédé selon l'une des revendications 1 à 14, **caractérisé en ce que** la structure de support formant cadre (LF) est reliée à la carte de circuit imprimé (PCB) par le biais d'une couche de brasure (L) contenant de l'étain.

**16.** Procédé selon l'une des revendications 1 à 15, **caractérisé en ce que** le composant électronique (SMD) est une diode électroluminescente (LED) réalisée sous forme de puce (DIE).

FIG. 1

EP 3 652 569 B1

FIG. 2

EP 3 652 569 B1

FIG. 3

FIG. 4

**IN DER BESCHREIBUNG AUFGEFÜHRTE DOKUMENTE**

**In der Beschreibung aufgeführte Patentdokumente**

- WO 0029784 A1
- DE 10340005 A1
- US 6407411 B1
- EP 2138761 A1
- DE 102015114095 A1
- WO 2017032809 A1
- EP 1876653 A
- DE 29812559 U1
- EP 3196334 A1

**In der Beschreibung aufgeführte Nicht-Patentliteratur**

- **HO, C. Y. et al.** Electrical resistivity of ten selected binary alloys systems. *J. Phys. Chem. Ref. Data,* 1983, vol. 12 (2), 183-322